# EUROPÄISCHE PATENTSCHRIFT

(11) **EP 2 609 636 B1**
(45) Veröffentlichungstag und Bekanntmachung des Hinweises auf die Patenterteilung: **31.12.2014**
(21) Anmeldenummer: 11757795.7
(22) Anmeldetag: 22.08.2011
(51) Int. Cl.: H01L 35/32, H01L 35/34

(54) **HALBLEITERELEMENT UND ISOLATIONSMATERIAL IN RINGFORM FÜR EIN THERMOELEKTRISCHES MODUL**
ANNULAR SEMICONDUCTOR ELEMENT AND ANNULAR INSULATION MATERIAL FOR A THERMOELECTRIC MODULE
ÉLÉMENT SEMICONDUCTEUR ET MATÉRIAU D'ISOLATION ANNULAIRE POUR UN MODULE THERMOÉLECTRIQUE

(30) Priorität: 23.08.2010 DE 102010035152
(43) Veröffentlichungstag der Anmeldung: 03.07.2013
(73) Patentinhaber: Emitec Gesellschaft für Emissionstechnologie mbH, 53797 Lohmar (DE)
(72) Erfinder: BRÜCK, Rolf, 51429 Bergisch Gladbach (DE); MÜLLER, Wilfried, 51789 Lindlar (DE); LIMBECK, Sigrid, 53804 Much (DE)
(74) Vertreter: Rössler, Matthias
(86) Internationale Anmeldenummer: PCT/EP2011/064351
(87) Internationale Veröffentlichungsnummer: WO 2012/025476

(56) Entgegenhaltungen:
- EP-A1- 1 780 807
- EP-A1- 1 780 811
- EP-A2- 0 644 599
- DE-A1-102006 010 740
- GB-A- 678 353
- JP-A- 7 106 641
- US-A- 2 702 828
- US-A- 3 054 840
- US-A1- 2005 022 855
- GAO MIN ET AL: "Ring-structured thermoelectric module", SEMICONDUCTOR SCIENCE AND TECHNOLOGY, IOP PUBLISHING LTD, GB, Bd. 22, Nr. 8, 1. August 2007 (2007-08-01) , Seiten 880-883, XP020115062, ISSN: 0268-1242, DOI: 10.1088/0268-1242/22/8/009

## Beschreibung

Die vorliegende Erfindung betrifft ein Halbleiterelement und ein Isolationsmaterial zur Isolierung von ringförmigen hintereinander angeordneten Halbleiterelementen. Diese Halbleiterelemente und das Isolationsmaterial werden in einem thermoelektrischen Modul eingesetzt, das einzeln oder in einer Mehrzahl einen thermoelektrischen Generator bildet, der zur Umwandlung thermischer Energie eines Abgases in elektrische Energie geeignet ist.

Das Abgas aus einem Verbrennungsmotor eines Kraftfahrzeugs besitzt thermische Energie, welche mittels eines thermoelektrischen Generators in elektrische Energie umgewandelt werden kann, bspw. um eine Batterie oder einen anderen Energiespeicher zu füllen und/oder elektrischen Verbrauchern die benötigte Energie direkt zuzuführen. Damit wird das Kraftfahrzeug mit einem verbesserten energetischen Wirkungsgrad betrieben, und es steht für den Betrieb des Kraftfahrzeugs Energie in größerem Umfang zur Verfügung.

Ein solcher thermoelektrischer Generator weist zumindest eine Mehrzahl thermoelektrischer Module auf. Solche thermoelektrischen Module weisen bevorzugt eine Vielzahl thermoelektrischer Elemente auf, die zwischen einer sogenannten Heißseite und einer sogenannten Kaltseite positioniert sind. Thermoelektrische Materialien hierfür sind von einer Art, dass diese effektiv thermische Energie in elektrische Energie umwandeln können (Seebeck-Effekt) und umgekehrt (Peltier-Effekt), abhängig. Die thermoelektrischen Elemente umfassen z. B. wenigstens zwei Halbleiterelemente, die jeweils p- und n-dotiert sind und zusammen die kleinste thermoelektrische Einheit bilden. Diese Halbleiterelemente sind aus thermoelektrischem Material und auf ihrer Ober- und Unterseite (hin zur Heißseite bzw. Kaltseite) wechselseitig mit elektrisch leitenden Brücken versehen, so dass jeweils n- und p-dotierte Halbleiterelemente miteinander verbunden sind. Üblicherweise dienen Keramikplatten bzw. Keramikbeschichtungen und/oder ähnliche Materialien der Isolierung der Halbleiterelemente gegeneinander oder der elektrischen Verbindung gegenüber einem die thermoelektrischen Elemente aufnehmenden Gehäuse. Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche thermoelektrische Elemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (nund p-dotiert) in direkten elektrischen Kontakt gebracht. Mittels eines angeschlossenen Lastwiderstands kann der Stromkreis geschlossen und somit elektrische Leistung abgegriffen werden.

Für den Einsatz in Kraftfahrzeugen sind insbesondere rohrförmige thermoelektrische Module geeignet, in denen Halbleiterelemente kreisringförmig hintereinander zwischen einem Innenrohr und einem Außenrohr angeordnet sind, wobei das Innenrohr oder das Außenrohr von dem heißen Abgas überströmt wird. Die Herstellung des thermoelektrischen Moduls ist jedoch sehr aufwendig, weil die Halbleiterelemente zwischen dem inneren Rohr und dem äußeren Rohr angeordnet werden müssen, wobei gleichzeitig Isolationsmaterial und elektrisch leitende Verbindungen vorzusehen sind. Insbesondere ist bei der Konstruktion derartigen rohrförmiger thermoelektrischer Module zu beachten, dass Wärmeausdehnungen der einzelnen Bauteile, insbesondere an der Heißseite, nicht die Funktion des thermoelektrischen Moduls eingrenzen oder sogar zu einer Zerstörung von Bauteilen innerhalb des thermoelektrischen Moduls führen. Aus EP 0 644 599 A1 sind ringförmige thermoelektrische Elemente bekannt, die einen radialen Schlitz aufweisen, so dass in Umfangsrichtung zumindest zwei Endflächen des ringförmigen Elements durch einen Spalt voneinander getrennt sind und einander gegenüberstehen. Die thermoelektrischen Elemente sind an diesen Endflächen jeweils elektrisch kontaktiert, so dass dort eine elektrische Spannung abgegriffen werden kann. Die thermoelektrischen Elemente werden für einen thermoelektrischen Generator verwendet.

In GAO MIN et. al "Ring-structured thermoelectric module", Semiconductor Science and Technology, IOP Publishing Ltd, GB, werden ringförmige thermoelektrische Elemente und Isolationsmaterialien vorgeschlagen sowie ein damit hergestelltes thermoelektrisches Modul. Weiterhin wird dort ein Verfahren zur Herstellung eines solchen Moduls beschrieben. Hiervon ausgehend ist es Aufgabe der vorliegenden Erfindung, die mit Bezug auf den Stand der Technik geschilderten Probleme zumindest teilweise zu lösen. Insbesondere soll ein Halbleiterelement und ein Isolationsmaterial angegeben werden, die für den Einbau in rohrförmige thermoelektrische Module geeignet sind, wobei die konstruktiven Herausforderungen zumindest teilweise gelöst bzw. vereinfacht werden. Somit soll auch ein temperaturbeständiges thermoelektrisches Modul herstellbar sein, das zudem einfach und kostengünstig zu montieren ist.

Diese Aufgaben werden gelöst mit einem Halbleiterelement gemäß den Merkmalen des Patentanspruchs 1 und mit einem Isolationsmaterial gemäß den Merkmalen des Patentanspruchs 4. Vorteilhafte Ausgestaltungen der Erfindung sowie die Integration dieser Elemente bzw. Materialien in übergeordnete Baueinheiten und ein Verfahren zum Herstellen dieser übergeordneten Baueinheiten sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Das erfindungsgemäße Halbleiterelement ist ringförmig und weist zumindest eine Nut auf, die in einer radialen Richtung von einer Umfangsfläche zu einer Außenumfangsfläche verläuft. Das Halbleiterelement hat somit einen Außendurchmesser und Innendurchmesser, so dass es im Zwischenraum zwischen einem Außenrohr und einem Innenrohr eines thermoelektrischen Moduls anordenbar ist. Das ringförmige Halbleiterelement kann insbesondere kreisrund, elliptisch oder auch polygonal ausgeführt sein, so dass in Umfangsrichtung kein konstanter Innendurchmesser oder Außendurchmesser vorliegen muss. Somit wird unter einer "Ringform" insbesondere ein scheibenförmiges Element mit einem inneren Loch verstanden.

Die Ringform des Halbleiterelements führt dazu, dass das Halbleiterelement eine Innenumfangsfläche und eine Außenumfangsfläche aufweist. Die Nut erstreckt sich nun von dieser Innenumfangsfläche zu der Außenumfangsfläche. Die Nut ist dabei so gebildet, dass eine Reduzierung der Materialstärke (aber noch kein Spalt) bereitgestellt wird. Somit bildet die Nut insbesondere eine Sollbruchstelle für das Halbleiterelement, die ggf. bei der Montage und/oder dem Betrieb des thermoelektrischen Moduls genutzt werden kann. So können bei der Montage und/oder im Betrieb auftretende Spannungen durch ein gezieltes Aufbrechen der Nut abgebaut und damit auch eine Anpassung an die Platzverhältnisse im thermoelektrischen Modul erreicht werden.

In besonders vorteilhafter Weise sind mehrere Nuten vorgesehen, die ebenfalls in radialer Richtung von einer Innenumfangsfläche zu einer Außenumfangsfläche verlaufen, so dass durch die Nuten (zusammenhängende) Ringsegmente gebildet werden. Das ringförmige Halbleiterelement wird in einem thermoelektrischen Modul so angeordnet, dass die Außenumfangsfläche oder die Innenumfangsfläche an einer Heißseite angeordnet ist und auf der entsprechenden anderen Fläche eine Kaltseite. Durch das dann über das Halbleiterelement vorliegende Temperaturpotential wird ein Wärmetransport in radialer Richtung durch das Halbleiterelement erzeugt, so dass das Halbleiterelement zur Erzeugung eines entsprechenden elektrischen Stroms eingesetzt werden kann.

Durch die radial verlaufende Nut wird damit der Wirkungsgrad des Halbleiterelements nicht oder zumindest nicht wesentlich eingeschränkt, sollte es hier zu einem Bruch des Halbleiterelements kommen. Es sind insbesondere höchstens acht (8) Nuten in einem Halbleiterelement vorgesehen, die insbesondere in Umfangsrichtung auf dem Halbleiterelement regelmäßig verteilt in einer radialen Richtung verlaufen und so das Halbleiterelement in Ringsegmente unterteilen.

Damit kann das Halbleiterelement regelmäßig als Ringelement während der Montage eines thermoelektrischen Moduls verwendet werden, so dass eine einfache Handhabung und auch ein einfacheres Lagern dieser Halbleiterelemente möglich werden. Gleichzeitig können so Wärmespannungen innerhalb eines thermoelektrischen Moduls notfalls dadurch ausgeglichen werden, dass das Halbleiterelement im Bereich einer Nut, also an der Sollbruchstelle des Halbleiterelements, bricht. Da durch diesen Bruch aber keine Trennung des Halbleiterelement in einer Umfangsrichtung erfolgt, sondern in einer Richtung parallel zu dem durch das Halbleiterelement fließenden Wärmestrom, wird auch der Wirkungsgrad des Halbleiterelements in diesem Fall nicht beeinträchtigt.

Gemäß einer weiteren besonders vorteilhaften Ausgestaltung des Halbleiterelements weist die Nut eine Breite in einer Umfangsrichtung des Halbleiterelements von höchsten 0,5 mm [Millimeter] auf. Dies gilt insbesondere für Halbleiterelemente, die einen größten Außendurchmesser von höchstens 25 mm [Millimeter] aufweisen.

Gemäß einer weiteren vorteilhaften Ausgestaltung des Halbleiterelements weist die Nut eine Tiefe auf, so dass das Halbleiterelement im Bereich der Nut eine Materialstärke von höchstens 50 % einer Wanddicke des Halbleiterelements aufweist. Das Halbleiterelement weist außerhalb der Nut üblicherweise eine konstante Wanddicke auf. Bevorzugt ist, dass das Halbleiterelement im Bereich der Nut eine Materialstärke von höchstens 25 % der Wanddicke aufweist. Insbesondere ist die Nut dabei im Querschnitt im Wesentlichen rechteckig gestaltet, das heißt sie weist in radialer Richtung zwischen der Innenumfangsfläche und der Außenumfangsfläche des Halbleiterelements eine gleiche Breite und Tiefe auf. Die Seitenwände der Nut können senkrecht zu den Seitenflächen des Halbleiterelements verlaufen, besonders bevorzugt ist aber ein dreieckiger Querschnitt der Nut, so dass im Nutgrund die Seitenwände der Nut in einer Linie zusammenlaufen und damit eine scharfkantige Sollbruchstelle vorliegt.

Gemäß einem weiteren Aspekt der Erfindung wird ein Isolationsmaterial in Ringform zur Isolierung eines Halbleiterelements und zur Anordnung an einer Seitenfläche des Halbleiterelements vorgeschlagen, wobei das Isolationsmaterial einen in der radialen Richtung verlaufenden Schlitz aufweist, der das Isolationsmaterial teilt.

Das Isolationsmaterial dient insbesondere zur elektrischen Isolierung von n- und p-dotierten Halbleiterelementen, insbesondere den vorstehend erfindungsgemäß vorgestellten Halbleiterelementen. Im Hinblick auf die Ringform wird auf die obigen Erläuterungen verwiesen.

Dabei weist das Isolationsmaterial einen in radialer Richtung verlaufenden Schlitz auf, der das Isolationsmaterial teilt. Insbesondere kann dieser Schlitz zumindest teilweise auch in einer Umfangsrichtung verlaufen, so dass das Isolationsmaterial zwischen einem Innendurchmesser und einem Außendurchmesser bzw. einer Innenumfangsfläche und einer Außenumfangsfläche eine Trennung in Umfangsrichtung aufweist.

Besonders bevorzugt ist, dass der Schlitz konisch verläuft, dass also die Breite des Schlitzes in radialer Richtung von einer Innenumfangsfläche zu einer Außenumfangsfläche bzw. von einem Innendurchmesser zum Außendurchmesser des Isolationsmaterials nicht gleichmäßig verläuft sondern insbesondere nach außen hin größer wird. Insbesondere ist der Schlitz so geformt, dass bei Zusammenpressen des Isolationsmaterials in einer Umfangsrichtung des Isolationsmaterials der Schlitz im Isolationsmaterial so geschlossen wird, dass die äußere und innere Form des Isolationsmaterials nicht wesentlich geändert wird, sondern nur der Innendurchmesser bzw. der Außendurchmesser des Isolationsmaterials verkleinert werden. Der Schlitz schränkt die Isolationswirkung des Isolationsmaterials dabei nicht ein. Benachbart angeordnete Halbleitermaterialien sind insbesondere ausschließlich über ihre Außenumfangsfläche und/oder Innenumfangsfläche elektrisch leitend miteinander verbunden.

Gemäß einer weiteren besonders vorteilhaften Ausgestaltung weist das Isolationsmaterial zumindest einen größeren Innendurchmesser oder einen größeren Außendurchmesser als ein benachbart angeordnetes Halbleiterelement auf. Diese Relation gilt insbesondere vor dem zu einem thermoelektrischen Modul verbauten Zustand des Isolationsmaterials und des Halbleiterelements. Vielmehr wird bei der konstruktiven Auslegung des thermoelektrischen Moduls darauf geachtet, dass die genannte Bedingung bei den als Einzelteilen vorliegenden Halbleiterelementen und den Isolationsmaterialien gegeben ist. Der Schlitz im Isolationsmaterial sollte daher zumindest so breit ausgeführt sein, dass ein Zusammenpressen des Isolationsmaterials einen Außendurchmesser bzw. eine Außenumfangsfläche des Isolationsmaterials erzeugt, die beim kompletten Verschließen des Schlitzes höchstens den Betrag der Außenumfangsfläche bzw. des Außendurchmessers des Halbleiterelements aufweisen. Gleichzeitig sollte der so erzeugte Innendurchmesser bzw. die Innenumfangsfläche des Isolationsmaterials mindestens so groß sein, wie der Innendurchmesser bzw. die Innenumfangsfläche des entsprechenden Halbleiterelements.

Durch eine entsprechende Ausgestaltung des Halbleiterelements und des Isolationsmaterials ist es nun möglich, diese Bauteile zu einem thermoelektrischen Modul anzuordnen und durch Zusammenpressen des Isolationsmaterials eine ebene Außenumfangsfläche bzw. Innenumfangsfläche dieses rohrförmigen Halbleiterelements zu erhalten. Insbesondere ist das Halbleiterelement und/oder das Isolationsmaterial eben ausgeführt, weist also mindestens eine ebene Seitenfläche auf. Bevorzugt sind beide Seitenflächen eben ausgeführt. Durch die ebene Ausführung der Seitenflächen ist eine Anordnung von Halbleiterelementen und Isolationsmaterialien hintereinander möglich. Das Halbleiterelement und das benachbarte Isolationsmaterial berühren sich entsprechend über ihre gesamte ebene Seitenfläche.

Es wird weiter ein thermoelektrisches Modul vorgeschlagen, dass zumindest ein erfindungsgemäßes Halbleiterelement und zumindest ein erfindungsgemäßes Isolationsmaterial aufweist. Dabei ist bevorzugt, dass die Halbleiterelemente und die Isolationsmaterialien abwechselnd nacheinander angeordnet sind (z. B. nach Art eines Stapels).

Weiterhin wird ein Verfahren zum Herstellen eines derartigen (bevorzugt erfindungsgemäßen) thermoelektrischen Moduls vorgeschlagen, das zumindest die folgenden Schritte aufweist:
a) Anordnen von zumindest jeweils einem (bevorzugt erfindungsgemäßen) Halbleiterelement und einem (bevorzugt erfindungsgemäßen) Isolationsmaterial abwechselnd hintereinander zu einem rohrförmigen Element,
b) Bereitstellen eines inneren Rohrs und eines äußeren Rohrs,
c) Anordnen des rohrförmigen Elements zwischen dem inneren Rohr und dem äußeren Rohr,
d) Kalibrieren zumindest des inneren Rohrs und/oder des äußeren Rohrs, so dass das rohrförmige Element zumindest eine glatte Innenumfangsfläche und/oder eine glatte Außenumfangsfläche aufweist.

Insbesondere werden die n- und p-dotierten Halbleiterelemente und Isolationsmaterialien (außen) auf dem inneren Rohr angeordnet, wobei das innere Rohr einen kleineren Außendurchmesser aufweist als der kleinste Innendurchmesser des rohrförmigen Elements, bestehend aus Halbleiterelementen und Isolationsmaterialien. Das äußere Rohr weist bevorzugt einen kleinsten Innendurchmesser auf, der größer ist als der entsprechend größte Außendurchmesser des rohrförmigen Elements, bestehend aus Halbleiterelementen und Isolationsmaterialien. Das Kalibrieren des inneren Rohres und/oder des äußeren Rohres hat insbesondere eine plastische Veränderung der Form des inneren Rohres und/oder des äußeren Rohres zur Folge, insbesondere in der Weise, dass das innere Rohr aufgeweitet und/oder das äußere Rohr reduziert wird. Damit kann eine sichere Anlage des inneren Rohres und/oder des äußeren Rohres hin zu den Halbleiterelementen und Isolationsmaterialien erreicht werden.

Sollten hierbei aufgrund von Fertigungstoleranzen lokal hohe Spannungen in das Modul eingebracht werden, können diese bei den erfindungsgemäßen Halbleiterelementen über die Nuten (Sollbruchstellen) und/oder die Spalte/Schlitze bei den Isolationsmaterialien abgebaut werden, ohne dass die Funktionalität des thermoelektrischen Moduls hierbei gefährdet wird.

Bevorzugt weist zumindest das innere Rohr und/oder das äußere Rohr elektrisch leitende Verbindungen sowie insbesondere auch eine elektrische Isolierung auf, so dass die wechselweise hintereinander angeordneten und von Isolationsmaterialien beanstandeten n- und p-dotierten Halbleiterelemente an ihren Außenumfangsflächen und Innenumfangsflächen jeweils gezielt elektrisch miteinander verbunden sind. Durch diese elektrisch leitende Verbindung der Halbleiterelemente (über die ringförmigen Isolationsmaterialien hinweg) kann ein elektrischer Strom durch das thermoelektrische Modul erzeugt und Verbrauchern oder Speichermedien zugeführt werden. Insbesondere sind dabei elektrisch leitende Verbindungen zur elektrischen Verbindung von n- und p-dotierten Halbleiterelementen auf der Außenumfangsfläche und wechselseitig dazu auf der Innenumfangsfläche so angeordnet, dass diese im Bereich der Nuten der Halbleiterelemente ebenfalls Aussparungen aufweisen.

Weiterhin wird ein Halbleiterelement bzw. ein Isolationsmaterial vorgeschlagen, dass an einer Seitenfläche eine Aussparung aufweist, die zur Aufnahme von Lotmaterial geeignet ist. Es wird hiermit ausdrücklich darauf hingewiesen, dass es sich hierbei um eine weitere, insbesondere unabhängige Erfindung handelt, die zu einem späteren Zeitpunkt aus der vorliegenden Erfindung herausgeteilt werden kann. Die im Folgenden auf ein Halbleiterelement bezogenen Ausführungen sind in gleicher Weise auf ein Isolationsmaterial anwendbar.

Das Halbleiterelement ist insbesondere ringförmig und weist an zumindest einer Seitenfläche eine Aussparung auf, die sich in Umfangsrichtung erstreckt. Diese Aussparung erstreckt sich an der Seitenfläche bis zur Innenumfangsfläche oder bis zur Außenumfangsfläche des Halbleiterelements und ist insbesondere vollständig umlaufend ausgeführt. Bei der Herstellung eines thermoelektrischen Moduls kann z. B. ringförmiges Lotmaterial in diesen Aussparungen angeordnet werden. Nach der Montage insbesondere zumindest der Komponenten Innenrohr, Isolierung, elektrisch leitende Verbindung auf der Innenumfangsseite der Halbleiterelemente, Halbleiterelemente mit Lotmaterial, Isolationsmaterial und elektrisch leitende Verbindung auf der Außenumfangsseite der Halbleiterelemente kann ein Lötprozess durchgeführt werden. Infolge dieses Lötprozesses wird das Lot in den Aussparungen aufgeschmolzen und verteilt sich selbstständig infolge der Kapillarwirkung zu den ausgewählten Verbindungsstellen. Weiterhin kann die Aussparung auch als Lotreservoir vorgesehen werden, so dass ein Überschuss an Lotmaterial in die Aussparung ausweichen kann, bzw. dort verbleibt.

Das Halbleiterelement bzw. Isolationsmaterial kann insbesondere auch andere Formen als die angegebene Ringform aufweisen. Insbesondere sind ringsegmentförmige, quaderförmige oder zylinderförmige Halbleiterelemente bzw. Isolationsmaterial geeignet.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: ein Halbleiterelement im Querschnitt,
- Fig. 2:: ein Halbleiterelement in einer Seitenansicht,
- Fig. 3:: ein Isolationsmaterial im Querschnitt,
- Fig. 4:: ein Isolationsmaterial in einer Seitenansicht,
- Fig. 5:: ein rohrförmiges Element gemäß Verfahrensschritt a),
- Fig. 6:: ein inneres und äußeres Rohr gemäß Verfahrensschritt b),
- Fig. 7:: den Verfahrensschritt c),
- Fig. 8:: das thermoelektrische Modul nach dem Kalibrieren zumindest eines Rohrs, und
- Fig. 9:: ein Halbleiterelement mit Aussparungen.

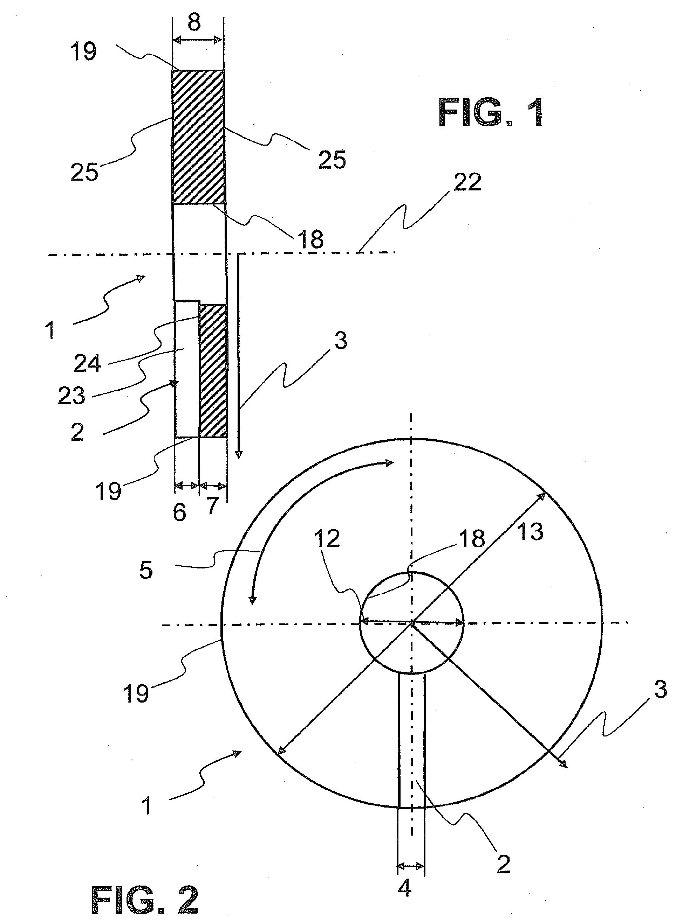

Fig. 1 zeigt ein Halbleiterelement 1 in einem Querschnitt. Das Halbleiterelement 1 ist ringförmig ausgebildet und weist eine Mittelachse 22 auf. Es weist weiter eine Innenumfangsfläche 18 und eine Außenumfangsfläche 19 auf sowie eine Nut 2, die von der Innenumfangfläche 18 bis zur Außenumfangsfläche 19 in einer radialen Richtung 3 verläuft. Weiterhin weist das Halbleiterelement 1 zwischen den Seitenflächen 25 eine Wanddicke 8 auf, wobei die Wanddicke 8 im Bereich der Nut 2 auf eine Materialstärke 7 reduziert wird, weil die Nut eine Tiefe 6 aufweist. Die Nut 2 wird durch Seitenwände 23 und einen Nutgrund 24 begrenzt.

Fig. 2 zeigt ein Halbleiterelement 1 aus Fig. 1 in einer Seitenansicht, wobei das Halbleiterelement 1 innen von einer Innenumfangsfläche 18 und außen von einer Außenumfangsfläche 19 begrenzt ist. Das Halbleiterelement 1 weist weiterhin einen Außendurchmesser 13 und einen Innendurchmesser 12 auf. Zwischen der Innenumfangsfläche 18 und der Außenumfangsfläche 19 verläuft die Nut 2, die eine Breite 4 aufweist, wobei die Breite 4 in Umfangsrichtung 5 betrachtet wird. Die Nut 2 verläuft in radialer Richtung 3 und bildet so eine Sollbruchstelle für das Halbleiterelement 1.

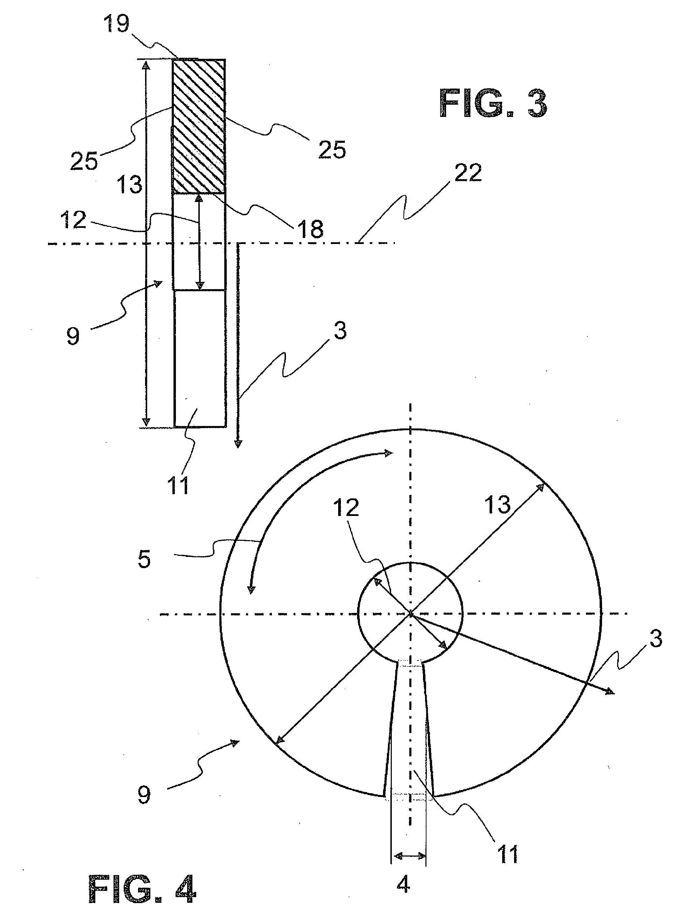

Fig. 3 zeigt das Isolationsmaterial 9 in einem Querschnitt. Das Isolationsmaterial 9 ist ringförmig um eine Mittelachse 22 angeordnet und weist einen Innendurchmesser 12 und einen Außendurchmesser 13 sowie Seitenflächen 25 auf, die das Isolationsmaterial 9 begrenzen. Weiterhin ist ein Schlitz 11 vorgesehen, der in einer radialen Richtung 3 durch das Isolationsmaterial 9 verläuft.

Fig. 4 zeigt das Isolationsmaterial 9 aus Fig. 3 in einer Seitenansicht. Der Schlitz 11 ist hier in radiale Richtung konisch ausgeführt und weist demnach eine mittlere (in radiale Richtung aber unterschiedliche) Breite 4 auf. Der Schlitz 11 verläuft folglich vom Innendurchmesser 12 hin zum Außendurchmesser 13 in radialer Richtung 3 und trennt somit das Isolationsmaterial 9 in Umfangsrichtung 5.

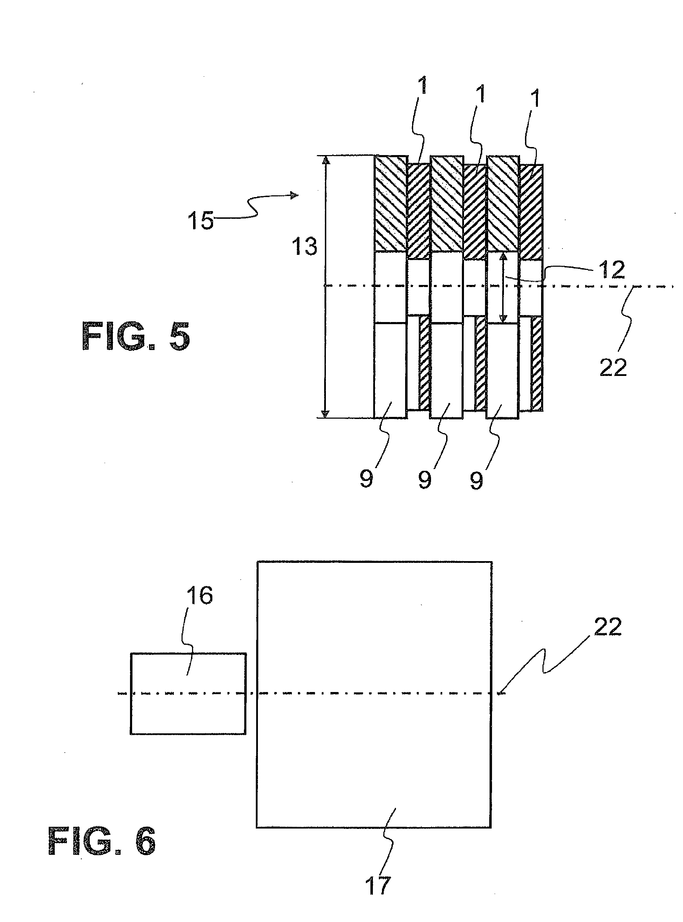

Fig. 5 zeigt den Verfahrensschritt a), demgemäß Isolationsmaterialien 9 und Halbleiterelemente 1 in Richtung einer Mittelachse hintereinander wechselweise angeordnet sind, wobei auch die Halbleiterelemente 1 jeweils als n- und p-dotiertes Halbleiterelement 1 wechselweise angeordnet sind. Das so entlang der Mittelachse 22 zusammengestellte rohrförmige Element 15 weist einen Außendurchmesser 13 auf, der durch den Außendurchmesser 13 des Isolationsmaterials 9 gegeben ist. Weiterhin ist ersichtlich, dass der Innendurchmesser 12 der Isolationsmaterialien 9 größer ist als der Innendurchmesser 12 der daneben angeordneten Halbleiterelemente 1.

Fig. 6 zeigt den Verfahrensschritt b), wobei ein inneres Rohr 16 und ein äußeres Rohr 17 bereitgestellt werden, die entlang einer Mittelachse 22 konzentrisch zu einem Gehäuse des thermoelektrischen Moduls zusammengeführt werden und das rohrförmige Elemente 15 in dem so gebildeten Zwischenraum aufnehmen.

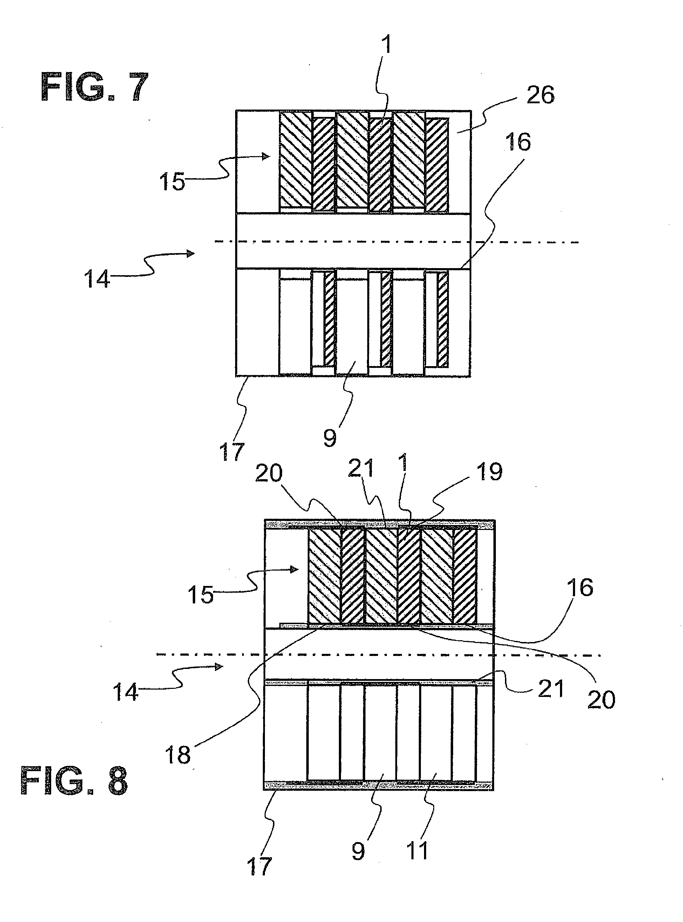

Fig. 7 zeigt Verfahrensschritt c), dem gemäß das rohrförmige Element 15 innerhalb des äußeren Rohrs 17 und um das innere Rohr 16 herum im Zwischenraum 26 zum Aufbau eines thermoelektrischen Moduls 14 angeordnet wird. Die Anordnung des rohrförmigen Elements 15 innerhalb des äußeren Rohrs 17 und auf dem inneren Rohr 16 ist im spannungsfreien Zustand dargestellt, das heißt, es wirken zu diesem Zeitpunkt keine radialen Kräfte auf die Isolationsmaterialien 9 bzw. die Halbleiterelemente 1.

Fig. 8 zeigt den Verfahrensschritt d), demgemäß das rohrförmige Element 15 nun innerhalb des äußeren Rohrs 17 und auf dem inneren Rohr 16 angeordnet ist und entsprechend ein thermoelektrisches Modul 14 bildet. Durch das Kalibrieren des äußeren Rohrs 17 bzw. des inneren Rohrs 16 werden zumindest die Isolationsmaterialien 9 so zusammengedrückt, dass sich eine glatte Außenumfangsfläche 19 bildet, die durch die Außenumfangsflächen der Isolationsmaterialien 9 und der Halbleiterelemente 1 erzeugt wird. Gleichzeitig stellt sich bevorzugt eine glatte Innenumfangsfläche 18 ein, die durch die Innenumfangsflächen 18 der Isolationsmaterialien 9 und der Halbleiterelemente 1 gebildet wird. Weiterhin sind elektrisch leitende Verbindungen 20 und Isolierungen 21 so angeordnet, dass eine wechselseitige elektrisch leitende Verbindung der Halbleiterelemente 1 über die Außenumfangsflächen 19 bzw. die Innenumfangsflächen 18 des rohrförmigen Elementes 15 ermöglicht wird und eine Isolierung 21 gegenüber dem inneren Rohr 16 bzw. dem äußeren Rohr 17 gewährleistet ist. Fig. 8 zeigt weiterhin, dass durch die Kalibrierung des inneren Rohrs 16 oder des äußeren Rohres 17 oder durch Wärmespannungen im Betrieb, die Nuten der Halbleiterelemente 1 einen radialen Bruch der Halbleiterelemente 1 bewirkt haben.

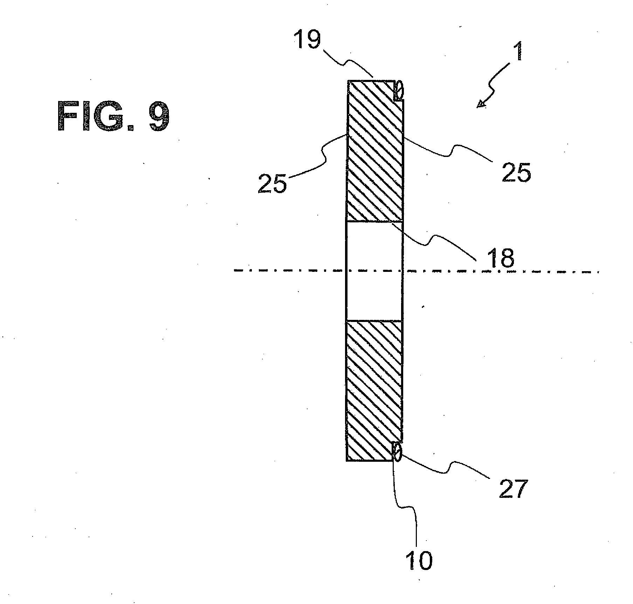

Fig. 9 zeigt ein ringförmiges Halbleiterelement 1 mit Seitenflächen 25 und einer Innenumfangsfläche 18 sowie einer Außenumfangsfläche 19. An der Seitenfläche 25 ist eine Aussparung 10 im Bereich der Außenumfangsfläche 19 angeordnet, in der ein Lotmaterial 27 angeordnet ist.

### Bezugszeichenliste

- 1: Halbleiterelement
- 2: Nut
- 3: radiale Richtung
- 4: Breite
- 5: Umfangsrichtung
- 6: Tiefe
- 7: Materialstärke
- 8: Wanddicke
- 9: Isolationsmaterial
- 10: Aussparung
- 11: Schlitz
- 12: Innendurchmesser
- 13: Außendurchmesser
- 14: Thermoelektrisches Modul
- 15: Rohrförmiges Element
- 16: Inneres Rohr
- 17: Äußeres Rohr
- 18: Innenumfangsfläche
- 19: Außenumfangsfläche
- 20: Elektrisch leitende Verbindung
- 21: Isolierung
- 22: Mittelachse
- 23: Seitenwand
- 24: Nutgrund
- 25: Seitenfläche
- 26: Zwischenraum
- 27: Lotmaterial

## Patentansprüche

1. Halbleiterelement (1) in Ringform, **dadurch gekennzeichnet, daß** das Halbleiterelement (1) zumindest eine Nut (2) aufweist, die in einer radialen Richtung (3) von einer Innenumfangsfläche (18) zu einer Außenumfangsfläche (19) verläuft.

2. Halbleiterelement (1) gemäß Patentanspruch 1, wobei die Nut (2) eine Breite (4) in einer Umfangsrichtung (5) des Halbleiterelements (1) von höchstens 0,5 mm aufweist.

3. Halbleiterelement (1) gemäß einem der vorhergehenden Patentansprüche, wobei die Nut (2) eine Tiefe (6) aufweist, so dass das Halbleiterelement (1) im Bereich der Nut (2) eine Materialstärke (7) von höchstens 50 % einer Wanddicke (8) des Halbleiterelements (1) aufweist.

4. Isolationsmaterial (9) in Ringform zur Isolierung eines Halbleiterelements (1) und zur Anordnung an einer Seitenfläche (25) des Halbleiterelements (1), wobei das Isolationsmaterial (9) einen in der radialen Richtung (3) verlaufenden Schlitz (11) aufweist, der das Isolationsmaterial (9) teilt.

5. Isolationsmaterial (9) gemäß Patentanspruch 4, wobei der Schlitz (11) konisch verläuft.

6. Isolationsmaterial (9) gemäß einem der Patentansprüche 4 oder 5, wobei das Isolationsmaterial (9) zumindest einen größeren Innendurchmesser (12) oder zumindest einen größeren Außendurchmesser (13) als ein benachbart angeordnetes Halbleiterelement (1) aufweist.

7. Thermoelektrisches Modul (14) aufweisend zumindest ein Halbleiterelement (1) gemäß einem der Patentansprüche 1 bis 3 und zumindest ein Isolationsmaterial (9) gemäß einem der Patentansprüche 4 bis 6.

8. Verfahren zum Herstellen eines thermoelektrischen Moduls (14) gemäß Patentanspruch 7, zumindest aufweisend die folgenden Schritte:
a) Anordnen von Halbleiterelementen (1) und Isolationsmaterialien (9) abwechselnd hintereinander zu einem rohrförmigen Element (15),
b) Bereitstellen eines inneren Rohrs (16) und eines äußeren Rohrs (17),
c) Anordnen des rohrförmigen Elements (15) zwischen dem inneren Rohr (16) und dem äußeren Rohr (17),
d) Kalibrieren zumindest des inneren Rohrs (16) oder des äußeren Rohrs (17), so dass das rohrförmige Element (15) zumindest eine glatte Innenumfangsfläche (18) oder eine glatte Außenumfangsfläche (19) aufweist.

## Claims

1. Annular semiconductor element (1), **characterized in that** the semiconductor element (1) has at least one groove (2) extending in a radial direction (3) from an internal circumferential surface (18) to an external circumferential surface (19).

2. Semiconductor element (1) as claimed in claim 1, wherein the groove (2) has a width (4) in a circumferential direction (5) of the semiconductor element (1) of at most 0,5 mm.

3. Semiconductor element (1) as claimed in one of the preceding claims, wherein the groove (2) has a depth (6) such that the semiconductor element (1) has in the region of the groove (2) a material thickness (7) of at most 50% of a wall thickness (8) of the semiconductor element (1).

4. Annular insulation material (9) for insulating a semiconductor element (1) and for arrangement on a lateral face (25) of the semiconductor element (1), wherein the insulation material (9) has a slit (11) which extends in the radial direction (3) and divides the insulation material (9).

5. Insulation material (9) as claimed in claim 4, wherein the slit (11) has a conical extent.

6. Insulation material (9) as claimed in one of claims 4 or 5, wherein the insulation material (9) has at least a larger internal diameter (12) or at least a larger external diameter (13) than a semiconductor element (1) which is arranged adjacently.

7. Thermo-electric module (14) having at least one semiconductor element (1) as claimed in one of claims 1 to 3, and at least one insulation material (9) as claimed in one of claims 4 to 6.

8. Method for manufacturing a thermo-electric module (14) as claimed in claim 7, having at least the following steps:
a) arranging of semiconductor elements (1) and insulation materials (9) alternately one behind the other to form a tubular element (15),
b) providing of an inner tube (16) and an outer tube (17),
c) arranging of the tubular element (15) between the inner tube (16) and the outer tube (17),
d) calibrating of at least the inner tube (16) or of the outer tube (17) with the result that the tubular element (15) has at least a smooth internal circumferential surface (18) or a smooth external circumferential surface (19).

## Revendications

1. Élément semi-conducteur (1) sous forme annulaire, **caractérisé en ce que** l'élément semi-conducteur (1) présente au moins une rainure (2) qui s'étend dans une direction radiale (3) depuis une surface périphérique interne (18) jusqu'à une surface périphérique externe (19).

2. Élément semi-conducteur (1) selon la revendication 1, dans lequel la rainure (2) présente une largeur (4) dans une direction périphérique (5) de l'élément semi-conducteur (1) de 0,5 mm au maximum.

3. Élément semi-conducteur (1) selon l'une quelconque des revendications précédentes, dans lequel la rainure (2) présente une profondeur (6) telle que l'élément semi-conducteur (1), dans la région de la rainure (2), présente une épaisseur de matériau (7) correspondant au maximum à 50 % d'une épaisseur de paroi (8) de l'élément semi-conducteur (1).

4. Matériau isolant (9) sous forme annulaire pour l'isolation d'un élément semi-conducteur (1) et destiné à être disposé sur une surface latérale (25) de l'élément semi-conducteur (1), le matériau isolant (9) présentant une fente (11) s'étendant dans la direction radiale (3), laquelle divise le matériau isolant (9).

5. Matériau isolant (9) selon la revendication 4, dans lequel la fente (11) s'étend sous forme conique.

6. Matériau isolant (9) selon l'une quelconque des revendications 4 ou 5, dans lequel le matériau isolant (9) présente au moins un plus grand diamètre intérieur (12) ou au moins un plus grand diamètre extérieur (13) qu'un élément semi-conducteur (1) adjacent.

7. Module thermoélectrique (14) présentant au moins un élément semi-conducteur (1) selon l'une quelconque des revendications 1 à 3 et au moins un matériau isolant (9) selon l'une quelconque des revendications 4 à 6.

8. Procédé de fabrication d'un module thermoélectrique (14) selon la revendication 7, présentant au moins les étapes suivantes :
a) disposition d'éléments semi-conducteurs (1) et de matériaux isolants (9) en alternance les uns derrière les autres pour former un élément tubulaire (15),
b) fourniture d'un tube interne (16) et d'un tube externe (17),
c) disposition de l'élément tubulaire (15) entre le tube interne (16) et le tube externe (17),
d) calibration d'au moins le tube interne (16) ou le tube externe (17), de telle sorte que l'élément tubulaire (15) présente au moins une surface périphérique interne lisse (18) ou une surface périphérique externe lisse (19).
